Europäisches Patentamt

European Patent Office

Office européen des brevets

(11) Publication number: **0 243 215**
**B1**

# EUROPEAN PATENT SPECIFICATION

(45) Date of publication of the patent specification:
01.08.90

(51) Int. Cl.⁵: **C30B 15/00**, C30B 33/00,
C30B 29/30

(21) Application number: 87400323.9

(22) Date of filing: 13.02.87

(54) A single crystal wafer of lithium tantalate.

(30) Priority: 18.02.86 JP 33251/86

(43) Date of publication of application:
28.10.87 Bulletin 87/44

(45) Publication of the grant of the patent:
01.08.90 Bulletin 90/31

(84) Designated Contracting States:
DE FR GB

(56) References cited:
JOURNAL OF CRYSTAL GROWTH, vol. 46, no. 2,
February 1979, pages 179-184, North-Holland Publishing
Co.; T. FUKUDA et al.: "Growth of LiTaO3 single crystal
for saw device applications"
PATENT ABSTRACTS OF JAPAN, vol. 10,
no. 120(C-343)(2177), 6th May 1986 &
JP-A-60 246 299 TOSHIBA K.K.) 05-12-1985

(73) Proprietor: SHIN-ETSU CHEMICAL CO., LTD., Asahitokai
Bldg. 6-1 Otemachi 2-chome, Chiyoda-ku Tokyo 100(JP)

(72) Inventor: Sakaguchi, Susumu, 3-28-4, Utsukushigaoka
Midori-ku, Yokohama-shi Kanagawa-ken(JP)
Inventor: Iguchi, Masaaki, A-8, 165-1, Goubara,
Annaka-shi Gunma-ken(JP)

(74) Representative: Armengaud, Charles et al, Cabinet
ARMENGAUD AINE 3, Avenue Bugeaud,
F-75116 Paris(FR)

Note: Within nine months from the publication of the mention of the grant of the European patent, any person may give notice to
the European Patent Office of opposition to the European patent granted. Notice of opposition shall be filed in a written reasoned
statement. It shall not be deemed to have been filed until the opposition fee has been paid (Art. 99(1) European patent
convention).

## Description

The present invention relates to a single crystal wafer of lithium tantalate provided with a so-called orientation flat formed with a high accuracy in the crystallographic orientation.

Single crystal of lithium tantalate is a material having a high electromechanical coupling coefficient with outstandingly small temperature dependency of various property parameters so that the single crystals of lithium tantalate are useful as a single crystal material of various kinds of SAW devices including resonators of VTR, PIF filters of television sets and the like as well as of various kinds of devices used in high-frequency communication instruments.

As is known, single crystals of lithium tantalate are usually grown by the so-called Czochralski method in which a single crystal is pulled up on a seed crystal from a melt having a chemical composition corresponding to $LiTaO_3$. The crystallographic direction of the Czochralski crystal growing of lithium tantalate single crystals is usually along the direction of the x-axis of the single crystal. The thus grown single crystal of lithium tantalate is subjected to a poling treatment to be converted into a single ferroelectric domain and then sliced in a plane perpendicular to the x-axis of the crystal into wafers, referred to as x-cut wafers hereinbelow, to be subjected to the subsequent processing for the manufacture of various devices.

It is usual that x-cut wafers of a lithium tantalate single crystal are provided with a so-called orientation flat which is a straightly plane surface formed on one peripheral portion of a wafer by shaving off a crescent-like portion from a circular wafer with an object to facilitate location of the preferred crystallographic direction for the propagation of the ultrasonic surface acoustic waves. Single crystal wafers of lithium tantalate are usually provided with an orientation flat formed by shaving along the plane parallel to the crystallographic direction of 112°Y as located by the X-ray Laue's method. In other words, the orientation flat is formed in the 112°Y direction assuming the propagating direction of the ultrasonic surface acoustic waves in this direction.

Due to the absence of any crystallographic lattice plane available for X-ray diffraction in this direction, however, the shaving works for forming the orientation flat in this direction must be performed by using a jig for holding the bladed wheel in a disposition for cutting parallel to the 112°Y direction with further fine adjustment of the blade direction by means of the back Laue's method so that the efficiency of working cannot be high enough. Moreover, good accuracy can not always be obtained in the crystallographic direction of the orientation flat located by the Laue's method in this manner with a considerably large deviation from the 112°Y direction so that the yield of acceptable products of the single crystal wafers is unavoidably decreased so much.

The present invention has been completed as a result of the investigations undertaken with an object to provide a solution for the above mentioned problems. The present invention provides an x-cut single crystal wafer of lithium tantalate having at least one orientation flat, the direction of the plane forming the orientation flat being parallel either:

(A) to the (018) plane of the single crystal or to a plane parallel to the x-axis of the single crystal and making an angle of 15° or smaller with the (018) plane of the single crystal;

or

(B) to a plane parallel to the x-axis and perpendicular to the (018) plane of the single crystal or to a plane parallel to the x-axis of the single crystal and making an angle of 15° or smaller with a plane perpendicular to the (018) plane of the single crystal.

As is understood from the above given summary of the invention, the most characteristic feature of the inventive single crystal wafer consists in the unique crystallographic orientation with which the plane of the orientation flat is formed. This means provides a solution for the problems in the prior art in respect of the low workability in the location of the proper crystallographic orientation as well as the poor accuracy in the location of the exact crystallographic orientation of the orientation flats so that the quality or performance of the devices made from the single crystal wafer as well as the yield of acceptable products can be greatly increased.

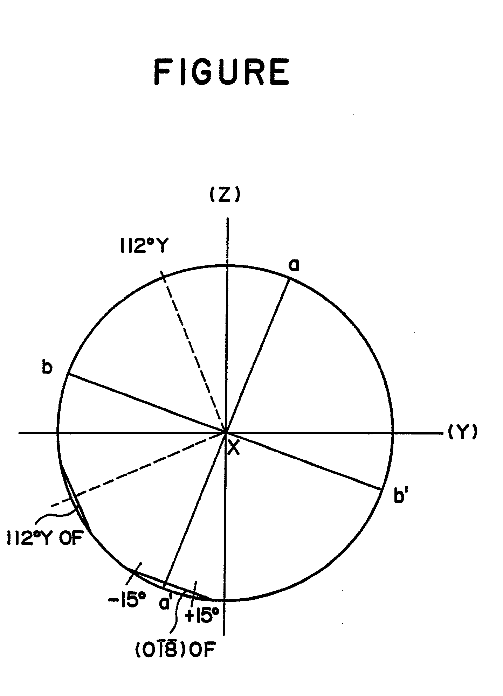

In the following, the inventive single crystal wafer of lithium tantalate is illustrated in more detail with reference to the accompanying drawing which is a projection of an x-cut single crystal wafer of lithium tantalate in the direction of the x-axis illustrating the crystallographic orientation of the orientation flat. For convenience in the figure, the y-axis and z-axis are taken in the horizontal and vertical directions, respectively, on the paper as is shown by (Y) and (Z). The points a and a' on the periphery of the circular wafer in the figure each indicate the point where the tangential plane is parallel to the (018) plane and the line b - b' is drawn perpendicularly to the line a - a'. An orientation flat is formed at the point a' in the direction perpendicular to the line a - a'. In other words, the plane of the orientation flat at the point a' is parallel to the (018) plane. The line marks at both sides of the point a' indicated by -15° and +15° show the ±15° limits of allowable deviation from the point a'. Each of the points a, b and b' may also be provided with such line marks limiting the ±15° deviation. When an orientation flat is formed at the point b, the plane of the orientation flat is parallel to a plane which is parallel to the x-axis and perpendicular to the (018) plane of the single crystal.

The (018) plane of the lithium tantalate single crystal is a lattice plane available for X-ray diffraction so that the (018) plane of the x-cut single crystal wafer can be easily and rapidly located by the X-ray diffractometry with high accuracy. Accordingly, the orientation flat according to the above given disclosure can be formed with very high accuracy relative to the crystallographic orientation so that the wafer can be used as a material for the manufactire of various SAW devices having greatly improved performance if not to mention the advantage in the increased yield of the acceptable products. It is of course that the inventive single crystal wafers provided with an orientation flat in the above specified crystallographic orientation can be prepared with greatly improved productivity in comparison with the conventional wafers provided with an orientation flat in the 112°Y direction which can be located only with considerable difficulties.

Similarly to the conventional single crystal wafers, the span of the orientation flat in the inventive single crystal wafer is of course not limitative depending on the diameter of the water, working efficiency in the subsequent processing and so on. Any mechanical working method can be applied for forming the orientation flat including grinding, cutting and the like.

Example.

A cylindrical single crystal boule of lithium tantalate having a diameter of about 80 mm and a length of about 100 mm was prepared by the Czochralski method of pulling up in the direction of the x-axis. After a poling treatment, the (018) plane of the single crystal was located with an accuracy of ±30″ using an X-ray diffractometric instrument for inspection.

Thereafter, the single crystal boule was ground on a cylinder grinding machine into a cylindrical form of 76.2 mm diameter, on which an orientation flat was formed by grinding to have a span of 22 mm in the direction parallel to the (018) plane. The single crystal is then sliced in a plane perpendicular to the x-axis to give wafers each having a thickness of 500 μm. These wafers were subjected to the inspection of the accuracy in the crystallographic orientation of the orientation flats to find that the variation was only ±30″ which was a much smaller value than ±0.5° considered unavoidable when the orientation flats were formed in the 112°Y direction. The wafers were further processed into SAW devices which had values of a resonance frequency with very small deviation from the value expected in the design so that the performance of the SAW devices was quite satisfactory and the yield of the acceptable products could also be improved.

## Claims

1. An x-cut single crystal wafer of lithium tantalate having at least one orientation flat, the direction of the plane forming the orientation flat being parallel either:

(A) to the (018) plane of the single crystal or to a plane parallel to the x-axis of the single crystal and making an angle of 15° or smaller with the (018) plane of the single crystal;
or

(B) to a plane parallel to the x-axis and perpendicular to the (018) plane of the single crystal or to a plane parallel to the x-axis of the single crystal and making an angle of 15° or smaller with a plane perpendicular to the (018) plane of the single crystal.

## Patentansprüche

1. Ein in x-Richtung geschnittener Einkristall-Wafer aus Lithiumtantalat mit mindestens einer flachen Orientierung, wobei die Richtung der Ebene, welche die flache Orientierung bildet, parallel verläuft entweder

(A) zu der (018)-Ebene des Einkristalls oder zu einer zur X-Achse des Einkristalls parallelen Ebene, welche mit der (018)-Ebene des Einkristalls einen Winkel von 15° oder weniger bildet, oder

(B) zu einer zur X-Achse parallelen und zur (018)-Ebene des Einkristalls senkrechten Ebene oder zu einer zur X-Achse des Einkristalls parallelen Ebene, welche mit einer zur (018)-Ebene des Einkristalls senkrechten Ebene einen Winkel von 15° oder weniger bildet.

## Revendications

1. Pastille de monocristal coupe x en tantalate de lithium, ayant au moins un plat d'orientation, la direction du plan formant le plat d'orientation étant parallèle soit:

(A) au plan (018) du monocristal ou à un plan parallèle à l'axe x du monocristal, et formant un angle de 15° ou moins avec le plan (018) du monocristal; soit

(B) à un plan parallèle à l'axe x et perpendiculaire au plan (018) du monocristal ou à un plan parallèle à l'axe x du monocristal et formant un angle de 15° ou moins avec un plan perpendiculaire au plan (018) du monocristal.

# FIGURE